# EUROPEAN PATENT APPLICATION

(11) **EP 4 827 315 A1**
(43) Date of publication of application: **21.10.2026**
(21) Application number: 25192021.1
(22) Date of filing: 27.07.2025
(51) Int. Cl.: H10W 90/22, H02M 1/00, H10W 90/00

(54) **DC-DC CONVERTER PACKAGE**

(30) Priority: 15.04.2025 EP 25170681
(71) Applicant: Photeon Technologies GmbH, 6850 Dornbirn (AT)
(72) Inventor: Schneider, Andreas, 6850 Dornbirn (AT); Morris, Timothy, 6850 Dornbirn (AT); Cappelletti, Andrea, 6850 Dornbirn (AT)
(74) Representative: Gangl, Markus

(57) **Abstract**

A package (1) for vertical power delivery to at least one electronic processing unit, comprising at least:
at least one DC-DC converter comprising at least:
a first monolithic sub-package (2) comprising at least one DC-DC converter;
a second monolithic sub-package (3) comprising at least one inductor electrically coupled to the at least one DC-DC converter;
one package output soldered pad (6) electrically coupled to the first monolithic sub-package (2);
one package input soldered pad (5) electrically coupled to the second monolithic sub-package (3);

wherein the first monolithic sub-package (2) and the second monolithic sub-package (3) are mounted to each other;
and a method for producing such a package (1).

## Description

The disclosure concerns a package for vertical power delivery to at least one electronic processing unit and a method for producing such a package.

In state-of-the-art packages in which the switches and inductors of DC-DC converters are arranged in a common monolithic block, delamination-effects can occur which can result in cracks traversing at least part of the interior of the package and which lead to unforeseeable changes in the behaviour of the package such that there is no reproducible behaviour between different packages.

It is an object to provide a package for vertical power delivery to at least one electronic processing unit which has reproducible behaviour and a method to produce such a package for vertical power delivery to at least one electronic processing unit.

This object is achieved by a package having the features of claim 1 and a method having the features of claim 16.

A package for vertical power delivery to at least one electronic processing unit comprises at least:
at least one DC-DC converter comprising at least:
   a first monolithic sub-package comprising at least one switch, the first monolithic sub-package having a first side and a second side;
   a second monolithic sub-package comprising at least one inductor electrically coupled to the at least one switch, the second monolithic sub-package having a first side and a second side;
one package input soldered pad electrically coupled to the at least one first monolithic sub-package;
one package output soldered pad electrically coupled to the at least one second monolithic sub-package.

In a method for producing a package for vertical power delivery to at least one electronic processing unit:
at least one first monolithic sub-package comprising at least one switch for a DC-DC converter, and
one package input soldered pad electrically coupled to the at least one switch;

are manufactured; and
   at least one second monolithic sub-package comprising at least one inductor for a DC-DC converter, and
   one package output soldered pad electrically coupled to the at least one inductor;
are manufactured; and
the at least one first monolithic sub-package and the at least one second monolithic sub-package are mounted to each other.

Due to the design of the at least one switch of the DC-DC-converter as part of a first monolithic sub-package and of the at least one inductor of the DC-DC converter as part of a separate second monolithic sub-package, wherein the first monolithic sub-package and the second monolithic sub-package are mounted to each other, delamination effects can be avoided.

Design of the at least one first monolithic sub-package and of the at least one second monolithic sub-package can be done independently from each other such that it is possible to change the design of only one of the monolithic sub-packages without the need to change the design of the whole package.

The package can be realized having very small vertical dimensions. **It** is possible to arrange transistors immediately under the package.

The package can be used for vertical power delivery to energy-demanding electronic processing units such as AI chips.

Embodiments are defined in dependent claims.

In some embodiments the at least one first monolithic sub-package and/or the at least one second monolithic sub-package are or is, respectively, formed by a die.

In some embodiments the at least one first monolithic sub-package and the at least one second monolithic sub-package are arranged in a vertical stack and the second side of the at least one first monolithic sub-package and the first side of the at least one second monolithic sub-package are mounted to each other.

In alternative embodiments the at least one first monolithic sub-package and the at least one second monolithic sub-package are arranged next to each other in a horizontal direction.

In some embodiments the package has at least one intermediate layer between the second side of the at least one first monolithic sub-package and the first side of the at least one second monolithic sub-package which electrically couples the at least one first monolithic sub-package and the at least one second monolithic sub-package. The at least one intermediate layer can comprise at least one electric redistribution layer.

In some embodiments the first side of the first at least one monolithic sub-package and/or the second side of the at least one second monolithic sub-package are or is, respectively, at least partially covered by at least one electric redistribution layer. The at least one electric redistribution layer is thermally conductive.

In some embodiments the first side of the at least one first monolithic sub-package and/or the second side of the at least one second monolithic sub-package are or is, respectively, at least partially covered by a passivation layer and the electric redistribution layer contacts the first side of the at least one first monolithic sub-package and/or the second side of the at least one second monolithic sub-package directly in a region in which there is no passivation layer.

In some embodiments the at least one first monolithic sub-package is integrated into a CMOS-wafer. Other types of wafers could be used.

In some embodiments:
on the second side of the at least one first monolithic sub-package there are arranged at least:
   one DC-DC input which is electrically connected to the at least one package input soldered pad,
   optionally one DC-DC ground which is electrically connected to the optional at least one package soldered ground pad,
   one DC-DC output;
the at least one DC-DC input and the at least one DC-DC ground being connected to the at least one DC-DC output by the at least one DC-DC-converter;
and wherein
on the first side of the at least one second monolithic sub-package there are arranged at least:
   one inductor input which is electrically connected to the at least one DC-DC output,
   one inductor output which is electrically connected to the at least one package output soldered pad;
the at least one inductor input and the at least one inductor output being connected by the at least one inductor.

In these embodiments input power enters the package at an input voltage and with an input current by the one package input soldered pad and output power leaves the package at an output voltage and with an output current by the at least one package output soldered pad.

The input power is transferred to the at least one DC-DC input and enters the at least one switch of the DC-DC converter. Power leaves the at least one first monolithic sub-package by the at least one DC-DC output and enters the at least one inductor by the at least one inductor input. Output power leaves by the package inductor output and is available at the at least one package output soldered pad.

In some embodiments the at least one DC-DC input, the at least one DC-DC ground, the at least one DC-DC output, the at least one inductor input and the at least one inductor output can be arranged in the optional at least one intermediate layer which can be arranged between the second side of the at least one first monolithic sub-package and the first side of the at least one second monolithic sub-package and which electrically couples the at least one switch and the at least inductor.

In some embodiments at least some of the electrical connections between the at least one switch and the at least one inductor which are used for power transfer are formed by eBars. An eBar is a solid piece of wire (e. g. made of copper) which can transfer more power than a via which, typically, has a hollow core.

In some embodiments vias or eBars can be used to transport signals across and/or within the package. It is possible to use copper-filled vias for power transfer.

In some embodiments the package is overmoulded such that the package is a monolithic arrangement.

In some embodiments at least one package ground soldered pad is arranged on the first side of the at least one first monolithic sub-package.

In some embodiments at least one capacitor, which is arranged between the at least one package input soldered pad and the at least one DC-DC input, is integrated in the package. One side of the at least one capacitor can be connected to the at least one package soldered input pad and the other side of the at least one capacitor can be connected to the at least one DC-DC ground. This allows to reduce ripples in the input power.

In some embodiments the package is of a generally rectangular shape, and it is preferred that it is constructed in a mirror-symmetrical way along a middle axis which at least approximately bisects the package.

In some embodiments the package has the following dimension(s):
a length in a range of about 2 to about 10 millimeter; and/or
a width in a range of about 2 to about 10 millimeter; and/or
a height in a range of about 200 to about 1000 micrometer.

In some embodiments the package, during operation, is configured to:
convert an input voltage in a range of about 1 volt to about 5 volt to an output voltage in a range of about 0,3 volt to about 2,5 volt; and/or
convert an input current in a range of about 0 ampere to about 120 ampere to an output current in a range of about 0 ampere to about 240 ampere.

In some embodiments at least one of the at least one inductor is a thin-film inductor.

In some embodiments at least one of the at least one inductor is a vertical inductor (this means that the terminals are on opposite sides on vertical axes). The vertical inductor can have several windings of a conductor or can have a straight conductor.

In such embodiments one terminal of the vertical inductor can be short to the output regulated voltage of the DC-DC converter which has the advantage of less dissipation.

It is possible to have both, at least one thin-film inductor and at least one vertical inductor, in the same embodiment. Alternatively, it is possible to have an embodiment with only thin-film inductor(s) or only vertical inductor(s).

In some embodiments of the method the at least one first monolithic sub-package and the at least one second monolithic sub-package are arranged in a vertical stack and are mounted to each other.

In some embodiments at least some of the soldered pads can be made of tin or gold plating.

In some embodiments the DC-DC input/output/ground and/or the inductor input/output can be surfaces of conductive pillars, e. g. made of copper.

In some embodiments, in which at least one thin-film inductor is used, the at least one thin-film inductor comprises at least one flat magnetic core with a conductive segment running along, around, through or between the at least one magnetic core wherein the conductive segment can have from one-half winding to at least one winding.

Embodiments are discussed having regard to the Figures. **It** is to be noted that the drawings are not to scale. **In** the Figures, in order not to overload the presentation, not all passivation layers are necessarily shown as it is clear to a person skilled in the art anyway at which positions such passivation layers are needed and not all structures are provided with reference signs.
Figure 1 shows a first cut view of a first embodiment along line B - B in Figure 2.
Figure 2 shows a top view of the first embodiment.
Figure 3 shows a second cut view of a first embodiment along line A-A in Figure 2.
Figure 4 shows a cut view of a second embodiment along line C - C in Figure 5.
Figure 5 shows a top view of the second embodiment.
Figure 6 shows a cut view of a third embodiment.
Figure 7 shows a cut view of a fourth embodiment.
Figure 8 shows a cut view of a fifth embodiment.

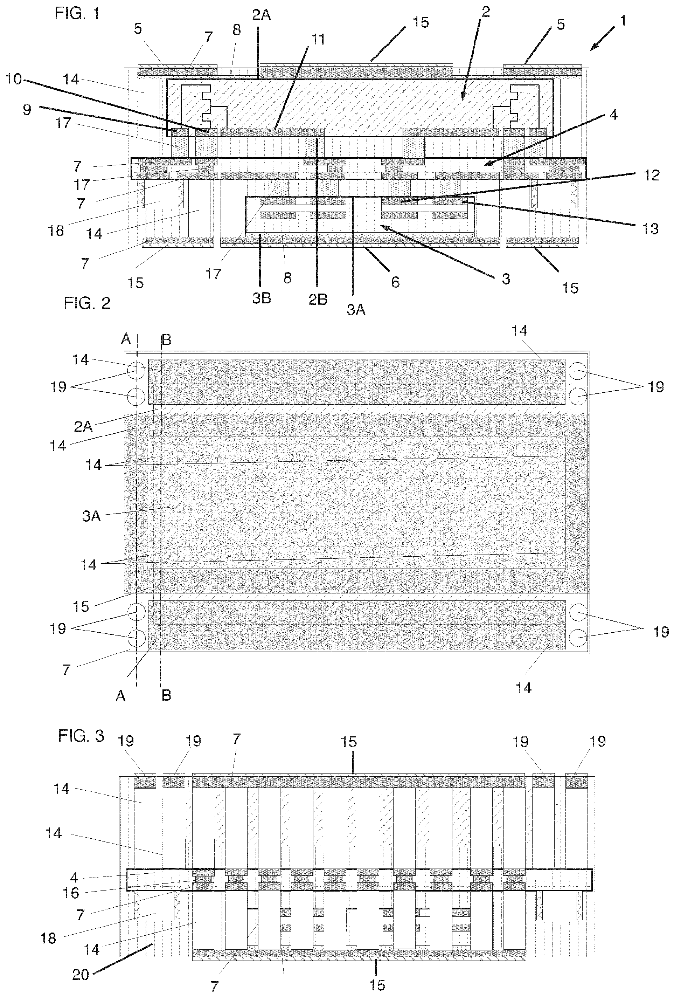

In Figures 1 to 3 a first embodiment of a package 1 for vertical power delivery is shown which comprises at least:
a first monolithic sub-package 2 comprising at least one switch of the DC-DC converter, the first monolithic sub-package having a first side 2A and a second side 2B;
one package input soldered pad 5 electrically coupled to the at least one switch;
a second monolithic sub-package 3 comprising at least one inductor electrically coupled to the at least one switch, comprising at least one thin-film inductor, the second monolithic sub-package having a first side 3A and a second side 3B;
one package output soldered pad 6 electrically coupled to the at least one inductor.

The first monolithic sub-package 2 and the second monolithic sub-package 3 are arranged in a vertical stack and the second side 2B of the first monolithic sub-package 2 and the first side 3A of the second monolithic sub-package 3 are mounted to each other.

The package 1 has at least one intermediate layer 4 between the second side 2B of the first monolithic sub-package 2 and the first side 3A of the second monolithic sub-package 3 which electrically couples the at least one switch and the at least inductor.

The first side 2A of the first monolithic sub-package 2 and the second side 3B of the second monolithic sub-package 3 are at least partially covered by an electric redistribution layer 7 which, in operation, acts as a thermal heat distribution layer.

The first side 2A of the first monolithic sub-package 2 and the second side 3B of the second monolithic sub-package 3 are at least partially covered by a passivation layer 8 and the electric redistribution layer 7 contacts the first side 2A of the first monolithic sub-package 2 and/or the second side 3B of the second monolithic sub-package 3 directly in a region in which there is no passivation layer 8.

In the first embodiment:
on the second side 2B of the first monolithic sub-package 2 there are arranged at least:
   one DC-DC input 9 which is electrically connected to the at least one package input soldered pad 5,
   one DC-DC ground10
   one DC-DC output 11;
   the at least one DC-DC input 9 and the at least one DC-DC ground 10 being connected to the at least one DC-DC output 6 by the at least one switch;
and wherein
   on the first side 3A of the second monolithic sub-package 3 there are arranged at least:
      one inductor input 12 which is electrically connected to the at least one DC-DC output 11,
      one inductor output 13 which is electrically connected to the at least one package output soldered pad 6;
   the at least one inductor input 12 and the at least one inductor output 13 being connected by the at least one inductor.

The at least one DC-DC input 9, the at least one DC-DC ground 10, the at least one DC-DC output 6, the at least one inductor input 12 and the at least one inductor output 13 are arranged in the optional at least one intermediate layer 13 which is arranged between the second side 2B of the first monolithic sub-package 2 and the first side 3A of the second monolithic sub-package 3 and which electrically couples the at least one switch and the at least inductor. The intermediate layer 4 comprises at least two electric redistribution layers 7 which partially run along the at least one intermediate layer 4 in different horizontal levels.

At least some of the electrical connections between the at least one switch and the at least one inductor which are used for power transfer are formed by eBars 14.

The package 1 is overmoulded such that the package 1 is a monolithic arrangement.

At least one optional package ground soldered pad 15 is arranged on the at least one first monolithic sub-package 2.

At least one optional capacitor 18 is arranged between the at least one package input soldered pad 5 and the at least one DC-DC input 10 is integrated in the package 1.

The package 1 is of a generally rectangular shape and it is constructed in a mirror-symmetrical way along a middle axis which bisects the package 1.

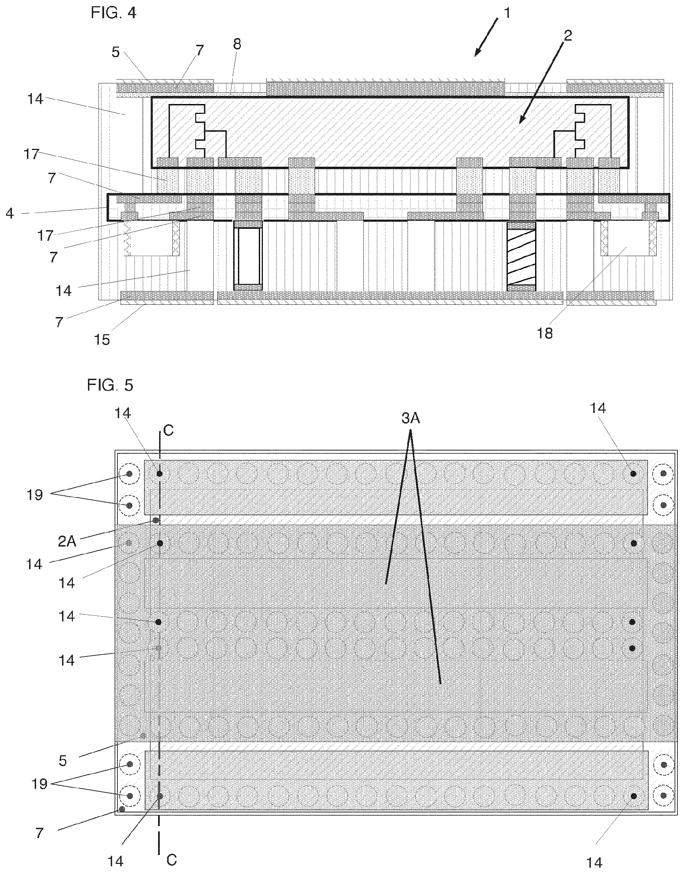

**In** the second embodiment of Figures 4 to 5 the package 1 comprises two second monolithic sub-packages 3 which are arranged next to each other in horizontal direction, and which are vertically stacked with the at least one sub-packages 2. The rest is as in the first embodiment.

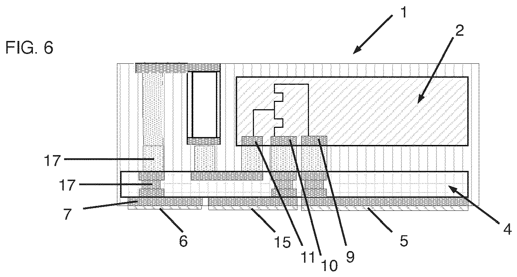

In the third embodiment of Figure 6 the first monolithic sub-package 2 and the second monolithic sub-package 3 are arranged next to each other in a horizontal direction. The rest is as in the first embodiment.

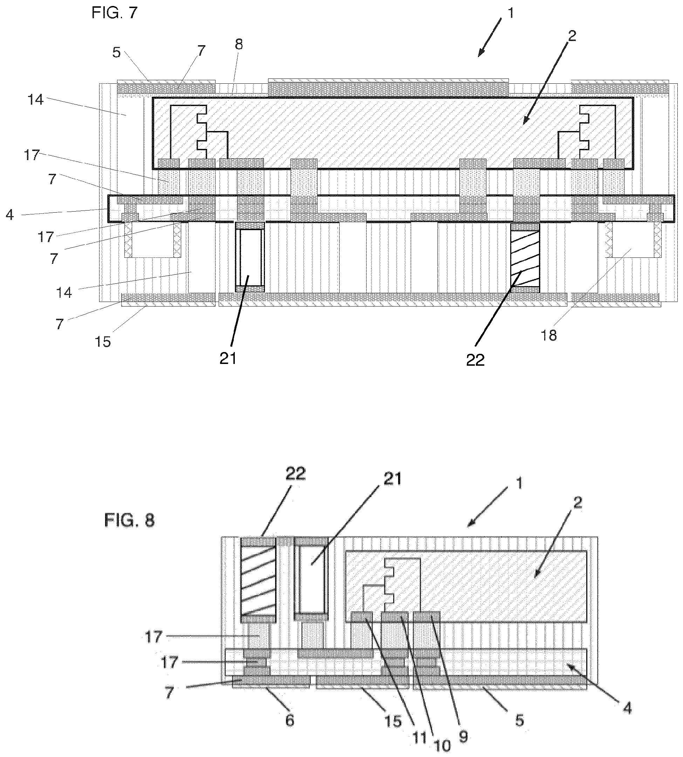

The fourth embodiment of Figure 7 is the same as the second embodiment of Figure 4 with the exception that the use of a vertical inductor 21 having a straight conductor and of a vertical inductor 22 having several windings instead of thin-film inductors is shown. One terminal of each vertical inductor 21, 22 can be short straight to the output regulated voltage of the DC-DC converter which has the advantage of less dissipation. Other than shown, vertical inductors 21, 22 of only one type (straight line or windings) could be used.

The fifth embodiment of Figure 8 is the same as the third embodiment of Figure 6 with the exception that the use of a vertical inductor 21 having a straight conductor and of a vertical inductor 22 having several windings instead of thin-film inductors is shown. As shown, to reduce package thickness, the vertical inductor(s) 21, 22 can be placed in a lateral position (a proper vertical metal connection can be made to mode the other terminal on the front side) and two vertical inductors 21 are place in series to increase the total inductivity. Other than shown, only a single vertical inductor 21, 22 could be used and/or vertical inductors 21, 22 of different types (straight line or windings) could be used.

List of reference signs:
- 1: package
- 2: first monolithic sub-package
2A first side of first monolithic sub-package
2B second side of first monolithic sub-package
- 3: second monolithic sub-package
3A first side of second monolithic sub-package
3B second side of second monolithic sub-package
- 4: intermediate layer
- 5: package input soldered pad
- 6: package output soldered pad
- 7: electric redistribution layer
- 8: passivation layer
- 9: DC-DC input
- 10: DC-DC ground
- 11: DC-DC output
- 12: inductor input
- 13: inductor output
- 14: eBar
- 15: package ground soldered pad
- 16: via
- 17: via between redistribution layers
- 18: capacitor
- 19: signal
- 20: mould compound
- 21: vertical inductor with straight conductor
- 22: vertical inductor with windings

## Claims

1. A package (1) for vertical power delivery to at least one electronic processing unit, comprising at least:
at least one DC-DC converter comprising at least:
a first monolithic sub-package (2) comprising at least one switch, the first monolithic sub-package having a first side (2A) and a second side (2B);
a second monolithic sub-package (3) comprising at least one inductor electrically coupled to the at least one switch, the second monolithic sub-package having a first side (3A) and a second side (3B);
one package input soldered pad (5) electrically coupled to the at least one first monolithic sub-package (2);
one package output soldered pad (6) electrically coupled to the at least one second monolithic sub-package (3).

2. The package of the preceding claim wherein the first monolithic sub-package (2) and the second monolithic sub-package (3) are arranged in a vertical stack and the second side (2B) of the first monolithic sub-package (2) and the first side (3A) of the second monolithic sub-package (3) are mounted to each other.

3. The package of the preceding claim wherein the package (1) has at least one intermediate layer (4) between the second side (2B) of the first monolithic sub-package (2) and the first side (3A) of the second monolithic sub-package (3) which electrically couples the at least one switch and the at least one inductor.

4. The package of one of the two preceding claims wherein the first side (2A) of the first monolithic sub-package (2) and/or the second side (3B) of the second monolithic sub-package (3) are or is, respectively, at least partially covered by an electric redistribution layer (7).

5. The package of the preceding claim wherein the first side (2A) of the first monolithic sub-package (2) and/or the second side (3B) of the second monolithic sub-package (3) are or is, respectively, at least partially covered by a passivation layer (8) and the electric redistribution layer (7) contacts the first side (2A) of the first monolithic sub-package (2) and/or the second side (3B) of the second monolithic sub-package (3) directly in a region in which there is no passivation layer (8).

6. The package of at least one of claims 2 to 5 wherein
on the second side (2B) of the first monolithic sub-package (2) there are arranged at least:
one DC-DC input (9) which is electrically connected to the at least one package input soldered pad (5),
one DC-DC ground (10),
one DC-DC output (11);
the at least one DC-DC input (9) and the at least one DC-DC ground (10) being connected to the at least one DC-DC output (6) by the at least one DC-DC-converter;
and wherein
on the first side (3A) of the second monolithic sub-package (3) there are arranged at least:
one inductor input (12) which is electrically connected to the at least one DC-DC output (11),
one inductor output (13) which is electrically connected to the at least one package output soldered pad (6);
the at least one inductor input (12) and the at least one inductor output (13) being connected by the at least one inductor.

7. The package of at least one of the preceding claims wherein at least some of the electrical connections between the first monolithic sub-package (2) and the second monolithic sub-package (3) which are used for power transfer are formed by eBars (14).

8. The package of at least one of the preceding claims wherein the package (1) is overmoulded such that the package (1) is a monolithic arrangement.

9. The package of at least one of the preceding claims wherein at least one package ground soldered pad (15) is arranged on the at least one first monolithic sub-package (2).

10. The package of at least one of the preceding claims wherein at least one capacitor (16), which is arranged between the at least one package input soldered pad (5) and the at least one DC-DC input (9), is integrated in the package (1).

11. The package of at least one of the preceding claims wherein the package (1) is of a generally rectangular shape and wherein it is preferred that it is constructed in a mirror-symmetrical way along a middle axis which at least approximately bisects the package (1).

12. The package of at least one of the preceding claims wherein the package (1) has the following dimension(s):
a length in a range of about 2 to about 10 millimeter; and/or
a width in a range of about 2 to about 10 millimeter; and/or
a height in a range of about 200 to about 1000 micrometer.

13. The package of at least one of the preceding claims wherein the package (1), during operation, is configured to:
convert an input voltage in a range of about 1 volt to about 5 volt to an output voltage in a range of about 0.3 volt to about 2.5 volt; and/or
convert an input current in a range of about 0 ampere to about 120 ampere to an output current in a range of about 0 ampere to about 240 ampere.

14. The package of at least one of the preceding claims wherein at least one of the at least one inductor is a thin-film inductor.

15. The package of at least one of the preceding claims wherein at least one of the at least one thin-film inductor is a vertical inductor (21, 22).

16. A method for producing a package (1) for vertical power delivery to at least one electronic processing unit, wherein:
at least one first monolithic sub-package (2) comprising at least one switch for a DC-DC converter, and
one input soldered pad (5) electrically coupled to the at least one switch;
are manufactured; and
at least one second monolithic sub-package (3) comprising at least one inductor for a DC-DC converter, and
one output soldered pad (6) electrically coupled to the at least one inductor;
are manufactured; and
the at least one first monolithic sub-package (2) and the at least one second monolithic sub-package (3) are mounted to each other.
